# EUROPEAN PATENT APPLICATION

(11) **EP 2 101 414 A1**
(43) Date of publication of application: **16.09.2009**
(21) Application number: 08102476.2
(22) Date of filing: 11.03.2008
(51) Int. Cl.: H03L 7/089

(54) **Charge pump circuit and method**

(71) Applicant: Seiko Epson Corporation, Shinjuku-ku Tokyo 163-0811 (JP)
(72) Inventor: Redondo Navarro, Xavier c/o Centro National de Microelectrónica, 08193 Barcelona (ES); Pallarès Cuxart, Jofre c/o Centro National de Microelectrónica, 08193 Barcelona (ES); Serra Graells, Francesc c/o Centro National de Microelectrónica, 08193 Barcelona (ES); Terés Terés, Lluís c/o Centro National de Microelectrónica, 08193 Barcelona (ES); Cairo Molins, Josep Ignasi c/o Epson Europe Electronics GmbH, 08190 Sant Cugat del Vallés (Barcelona) (ES); Gil Gali, Ignacio c/o Epson Europe Electronics GmbH, 08190 Sant Cugat del Valles (Barcelona) (ES); Tanaka, Kazuaki c/o Epson Europe Electronics GmbH, 08190 Sant Cugat del Vallés (Barcelona) (ES)
(74) Representative: Carpintero Lopez, Francisco

(57) **Abstract**

A charge pump circuit (20, 30) comprising: a first operational amplifier (230, 330) having a first input node (221, 321), a second input node (222, 322) and an output node (220, 320), said first operational amplifier (230, 330) being configured for adjusting the voltage at said output node (220, 320) to a reference value provided at said first input node (221, 321); a first current source (210, 310) and a second current source (211, 311) for providing respective first (I₂₁₀, I₂₁₁) and second (I₃₁₀, I₃₁₁) currents to said second input node (222, 322); a first switch (200, 300) and a second switch (201, 301) respectively configured for determining the amount of current (I₂₁₀, I₂₁₁; I₃₁₀, I₃₁₁) delivered to said second input node (222, 322); a loop filter (250, 350) configured for receiving a current difference between said first (I₂₁₀, I₂₁₁) and second (I₃₁₀, I₃₁₁) currents provided at said second input node (222, 322). It further comprises an automatic calibration circuit (280, 380) configured for directly controlling the current (I₂₁₀, I₃₁₀) provided by said first current source (210, 310). Method of calibrating a charge pump circuit (20, 30).

## Description

### FIELD OF THE INVENTION

The present invention relates to the field of frequency synthesizer phase-locked loops (PLLs) and, more particularly, to charge pumps for operating these devices.

### STATE OF THE ART

Frequency synthesizer phase-locked loops (PLLs) are commonly used in radio-frequency (RF) communications systems. These devices normally require a charge pump circuit for adjusting the voltage at the output of the PLL, by charging a capacitance.

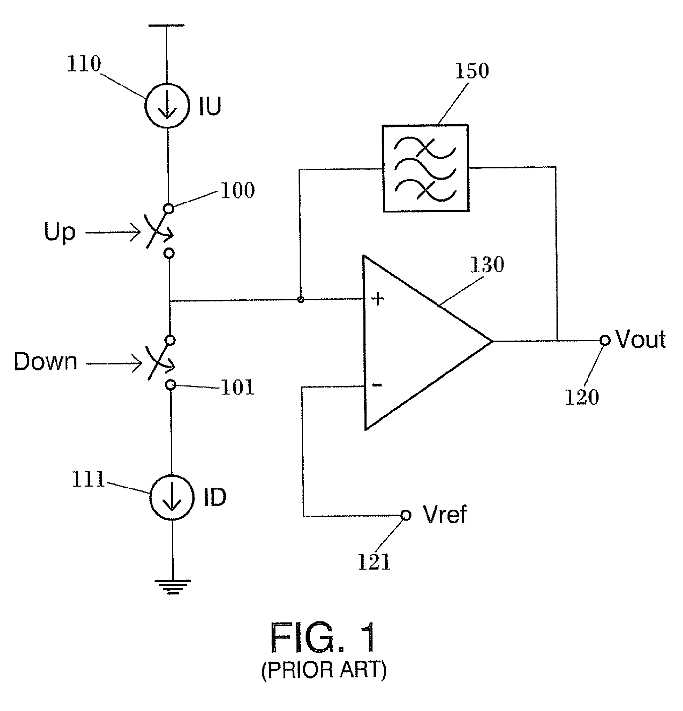

Figure 1 shows a typical schematic of a charge pump circuit. It comprises two switches 100 101 and two current sources 110 111. Switches 100 101 are controlled by respective signals Up and Down, as indicated in figure 1, and determine the amount of charge integrated by the loop filter 150. The operational amplifier 130 adjusts the output voltage Vout at the output 120 to a value close to a reference voltage Vref 121.

Ideally, both current sources 110 111 have the same value (IU=ID). This means that, if the switches 100 101 are closed during exactly a same period of time, the net charge injected to the filter 150 is zero. However, an unbalance between the currents IU and ID results in a certain amount of charge injected or drained from the loop filter 150, producing an error that can cause spurs in the frequency output of the PLL.

In a typical CMOS-based charge pump circuit, the current unbalance is mainly caused by the different type of transistors who are acting as current source 110 111. Commonly, the current from the IU source 110 is delivered through a P-type CMOS transistor (PMOS transistor), while the current from the ID source 111 is drained by an N-type CMOS transistor (NMOS transistor). Since different fabrication processes have been applied to obtain NMOS or PMOS transistors, some current mismatch is expected after fabrication.

US patent US6664829 discloses a charge pump circuit which, in addition to the current branch which provides the already mentioned upper and lower current sources, it has an additional current branch that copies the currents produced by those upper and lower current sources. This copy is made by using current sources mirrored to the later ones, and scaled by a factor M. The lower current sources I(D) and I(D)/M are controlled by a fixed reference signal, while the current flowing through the upper sources I(U) and I(U)/M is commanded by a PUMP UP CONTROL signal (PUC). Every time that UP and DOWN control signals are activated simultaneously (calibration phase), the amplifier adjusts the PUC signal so as to minimize the difference between its voltage inputs. Once this state is reached, the voltage at the capacitor should remain constant and there should be no current difference between sources I(U)/M and I(D)/M. As I(U) and I(D) are mirrored to the later ones, they should have also the same current.

### However, this device presents several disadvantages:

Firstly, once the calibration phase is ended, if the voltage at the input of the loop filter changes due to the typical charge pump operation, the PUC signal also changes, therefore unbalancing the currents. Secondly, although the I(U) and I(U)/M current sources are implemented with the same type of transistors and in principle only a scaling factor differentiates them, there is always an intrinsic mismatch due to the fabrication process. The same mismatch problem arises also between sources I(D) and I(D)/M. All these mismatches increase the already mentioned current unbalance.

### SUMMARY OF THE INVENTION

The present invention addressed the above-mentioned problems by providing an automatic current source balancing circuit. The automatic current source balancing circuit directly controls one of the current sources. Furthermore, the circuit of the invention allows two modes of operation, thus permitting to isolate the calibration circuitry when the circuit works in normal mode.

It is a primary aim of the present invention to provide a charge pump circuit comprising: a first operational amplifier having a first input node, a second input node and an output node, this first operational amplifier being configured for adjusting the voltage at that output node to a reference value provided at that first input node; a first current source and a second current source for providing respective first and second currents to that second input node; a first switch and a second switch respectively configured for determining the amount of current delivered to that second input node; a loop filter connected between the second input node and that output node, that loop filter being configured for integrating a current difference between those first and second currents provided at that second input node. It further comprises an automatic calibration circuit configured for directly controlling the current provided by said first current source.

The automatic calibration circuit preferably comprises a second operational amplifier having a first input node, a second input node and an output node, wherein that output node is connected to the first current source. This second input node of the second operation amplifier is preferably connected to the output node of the first operational amplifier through a third switch That first input node of the second operation amplifier is preferably connected to the second input node of the first operation amplifier through a fourth switch.

Preferably, the automatic calibration circuit further comprises a first capacitance connected to said first input node of the second operation amplifier and a second capacitance connected to the second input node of the second operation amplifier. These capacitances have their respective opposing end connected to ground and are configured for storing their voltage value.

Preferably, the automatic calibration circuit further comprises a third capacitance connected to the output node of the second operation amplifier.

In a particular embodiment, at least one of the first current source or the second current source is implemented by means of a PMOS transistor.

The charge pump circuit is configured for having two modes of operation: a calibration mode when both third and fourth switches are closed and a normal charge pump mode when both third and fourth switches are open.

It is another aim of the present invention to provide a frequency synthesizer phase-locked loop comprising the charge pump circuit previously mentioned.

It is another aim of the present invention to provide a system comprising that frequency synthesizer phase-locked loop. This system is preferably a radio-frequency communications system.

It is another aim of the present invention to provide a method of calibrating a charge pump circuit, the charge pump circuit comprising a first operational amplifier having a first input node, a second input node and an output node; a first current source and a second current source for providing respective first and second currents to said second input node; a first switch and a second switch respectively configured for determining the amount of current delivered to the second input node; a loop filter connected between the second input node and the output node, that loop filter being configured for integrating a current difference between the first and second currents provided at the second input node. The method comprising the steps of: detecting at a first input of a second operation amplifier a voltage value measured at the output of the first operation amplifier; comparing the detected voltage value to the voltage value at the first input of the first operation amplifier; producing an output voltage at the output of the second operation amplifier, that output voltage being proportional to the detected voltage value; adjusting the current of the first current source by means of the output voltage produced at the output of the second operation amplifier.

The advantages of the proposed invention will become apparent in the description that follows.

### BRIEF DESCRIPTION OF THE DRAWINGS

To complete the description and in order to provide for a better understanding of the invention, a set of drawings is provided. Said drawings form an integral part of the description and illustrate a preferred embodiment of the invention, which should not be interpreted as restricting the scope of the invention, but just as an example of how the invention can be embodied. The drawings comprise the following figures:
Figure 1 shows a conventional charge pump circuit.
Figure 2 shows a charge pump circuit according to an embodiment of the present invention.
Figure 3 is an automatic balancing circuit according to a preferred embodiment of the present invention.
Figure 4 shows an exemplary loop filter used in the charge pump circuit of the present invention.
Figure 5 shows a frequency synthesizer phase-locked loop comprising a charge pump circuit (20, 30) according to any embodiments of the invention.

### DESCRIPTION OF PREFERRED EMBODIMENTS OF THE INVENTION

In the context of the present invention, the terms "approximately", "about" and "around" and terms of its family (such as "approximate", etc.) should be understood as indicating values very near to those which accompany the aforementioned term. That is to say, a deviation within reasonable limits from an exact value should be accepted, because the expert in the technique will understand that such a deviation from the values indicated is inevitable due to measurement inaccuracies, etc.

The implementation of the present invention can be carried out as follows:

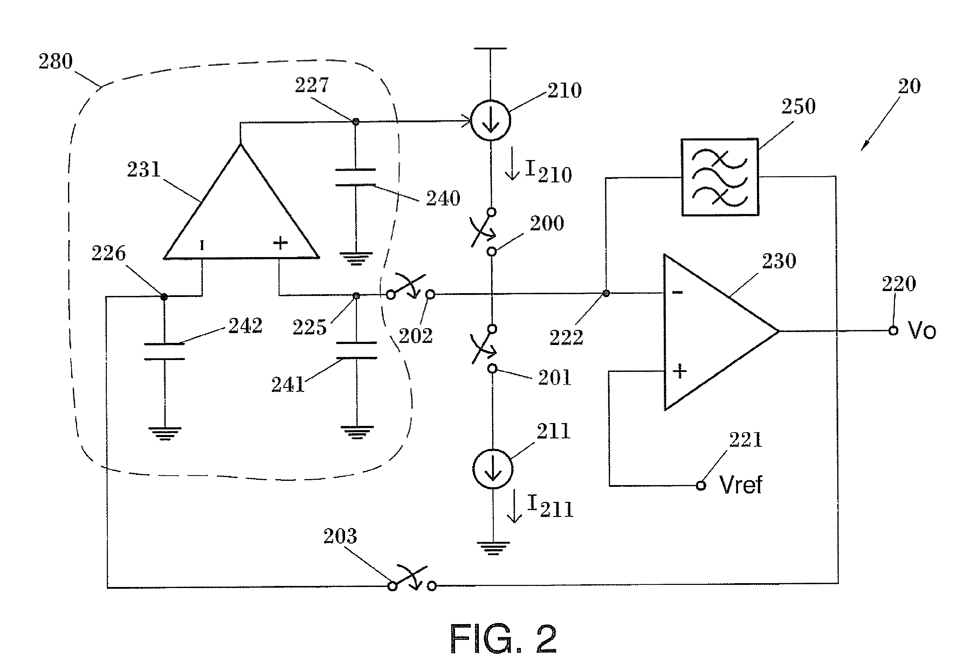

Figure 2 shows a schematic implementation of a charge pump circuit 20 according to the present invention. It is based on the conventional charge pump circuit depicted in figure 1. Like the one in figure 1, it comprises two switches 200 201 and two current sources 210 211. Switches 200 201 determine the amount of charge integrated by a loop filter 250. It also comprises an operational amplifier 230, which adjusts the output voltage Vo at the output 220 to a value close to a reference voltage Vref 221. Within this context, the expression "close to" is to be interpreted such that the difference between both voltages Vo and Vref must be, at utmost, two orders of magnitude below the voltage swing of the operational amplifier 230. The feedback of the operational amplifier 230 ensures a constant voltage at their inputs 221 222, equal to a reference voltage Vref, which is fixed through node 221. This allows a certain degree of relaxation in the design of the current sources 210 211, since the voltage at its output node 222 remains constant and with a known value. In a particular embodiment, the feedback is a negative feedback.

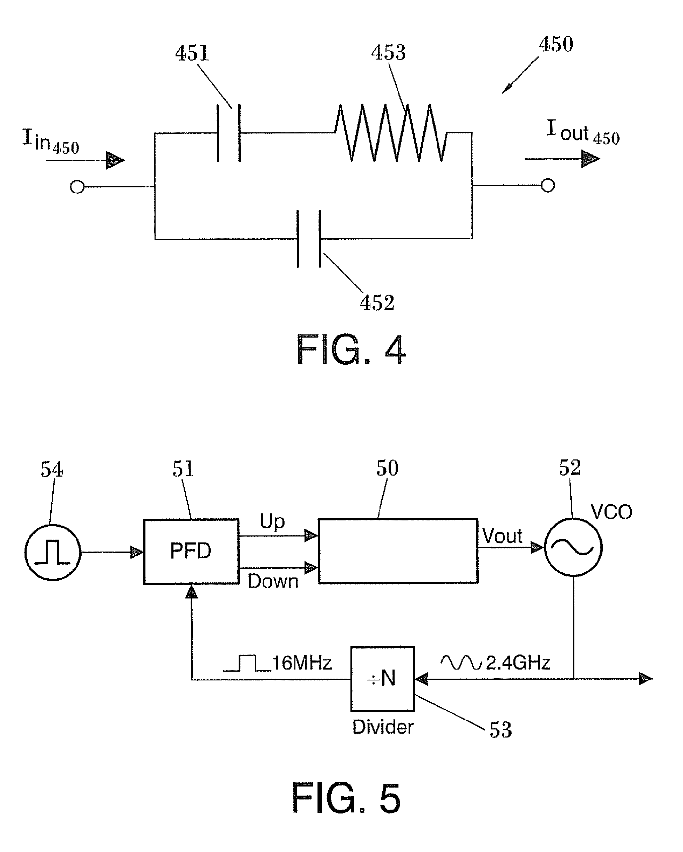

However, as already indicated with respect to figure 1, no current matching is guarantied between the currents provided by both sources 210 211. The loop filter 250 is a two-port circuit. Figure 4 shows a possible implementation of such filter: It comprises first and second capacitors 451 452 and a resistor 453. As can be appreciated in figure 4, loop filter 450 has neither ground nor power supply connections, ensuring that the input current is equal to the output current. In addition, the voltage between its input and output ports is increased or decreased if current Iᵢₙ₄₅₀ is positive or negative, respectively, since the difference in voltage in capacitors 451 452 is the integral of it respective input current.

The circuit of figure 2 further has a second block 280 forming a calibration circuit. It comprises a second operational amplifier 231 and a group of capacitances 240 241 242. This second block 280 is connected to or disconnected from the main block through switch 202 and switch 203, as shown in figure 2. The output 227 of the operational amplifier 231 is connected to current source 210.

Going back to figure 2, the circuit has two modes of operation: a calibration mode and a normal charge pump mode:

When switches 202 and 203 are open, circuit 20 works in a similar way as the circuit shown in figure 1. It then operates as a conventional charge pump circuit. Note that the upper current source 210 does not have a fixed value. It is, in this case, controlled by an input signal. It is to be noted that, when switches 202 and 203 are open, capacitors 240 241 242 work as a memory, storing their voltage value.

When the circuit works in calibration mode, both switches 202 203 are closed. Due to the constant voltage at the central node 222 and to the negative input 222 of the operational amplifier 230, the difference in current between the current provided by current source 210 and the current provided by current source 211 goes to the loop filter 250. Note that it cannot go to the capacitor 241, because it would change the voltage in the central node 222. This difference in current is integrated by the loop filter 250. In the context of the present disclosure, the term "integrates should take the meaning of the "integration" mathematical function. Thus, the loop filter integrates the current signal, transforming it to a voltage difference. As a consequence, there is a voltage change at the output 220 of the operation amplifier 230 which is proportional to the error or difference in current between sources 210 211. This change in the output voltage Vo 220 is sensed at the input 226 of the second operational amplifier 231, producing an output voltage 227 proportional to the voltage difference between the central node 222 and node 220. This output voltage 227 controls the upper current source 210, causing an increase or decrease of the current value it provides.

If, for example, the current I₂₁₀ which flows through source 210 is greater than the current I₂₁₁ which flows through source 211, the excess current (I₂₁₀ - I₂₁₁) flows towards the loop filter 250. Therefore, the voltage Vo at the node 220 decreases. If the voltage at the negative input 222 of the operational amplifier 231 decreases, there is an increase in the output voltage Vo at node 220. Since this voltage Vo is the value that controls the upper current source 210, the current of this source I₂₁₀ is decreased.

Preferably, this current source 210 is achieved by means of a PMOS transistor, which has a negative transconductance. Alternatively, this current source 210 is achieved by means of an NMOS transistor, in which case the two inputs 221 222 of the operation amplifier 230 must be interchanged (positive into negative and vice versa).

The current source 211 can be controlled by any conventional controlling means known by the skilled person in the art, such as a signal of constant value. The way the current source 211 is controlled is out of the scope of the present invention.

If, on the contrary, the current I₂₁₀ which flows through source 210 is lower than the current I₂₁₁ which flows through source 211, the excess current (I₂₁₁ - I₂₁₀) is drained from loop filter 250. Therefore, the voltage Vo at the node 220 increases. If the voltage at the negative input 222 of the operational amplifier 231 increases, there is a decrease in the output voltage Vo at node 220. Since this voltage Vo is the value that controls the upper current source 210, the current of this source I₂₁₀ is increased.

These voltage changes last until the current which flows through both sources 210 211 becomes equal. In this case, no more current is injected to the loop filter 250. As a consequence, output voltage Vo at node 220 remains constant and the upper current source 210 is then calibrated. At that instant of time, if switches 202 and 203 pass to an open position (open circuit), the circuit switches from calibration mode to normal operation mode. Thus, the charge pump circuit 20 operates in normal mode, without any current unbalance. The capacitors 240 241 242 of the second block 280 act as a memory, in order to keep and memorize all the voltage values at both the inputs 226 225 and output 227 of the operational amplifier 231 after the calibration period.

Next, table I gathers the allowed combinations of states of the four switches 200 201 202 203 of the circuit of figure 2. The combinations not gathered by table I are not allowed:

**Table I**

| SW 200 | SW 201 | SW 202 | SW 203 | Mode of operation of circuit 20 |
|---|---|---|---|---|
| OPEN | OPEN | OPEN | OPEN | Charge pump |
| OPEN | CLOSED | OPEN | OPEN | Charge pump |
| CLOSED | OPEN | OPEN | OPEN | Charge pump |
| CLOSED | CLOSED | OPEN | OPEN | Charge pump |
| CLOSED | CLOSED | CLOSED | CLOSED | Calibration mode |

Therefore, a simple and efficient way of balancing a charge pump circuit is provided.

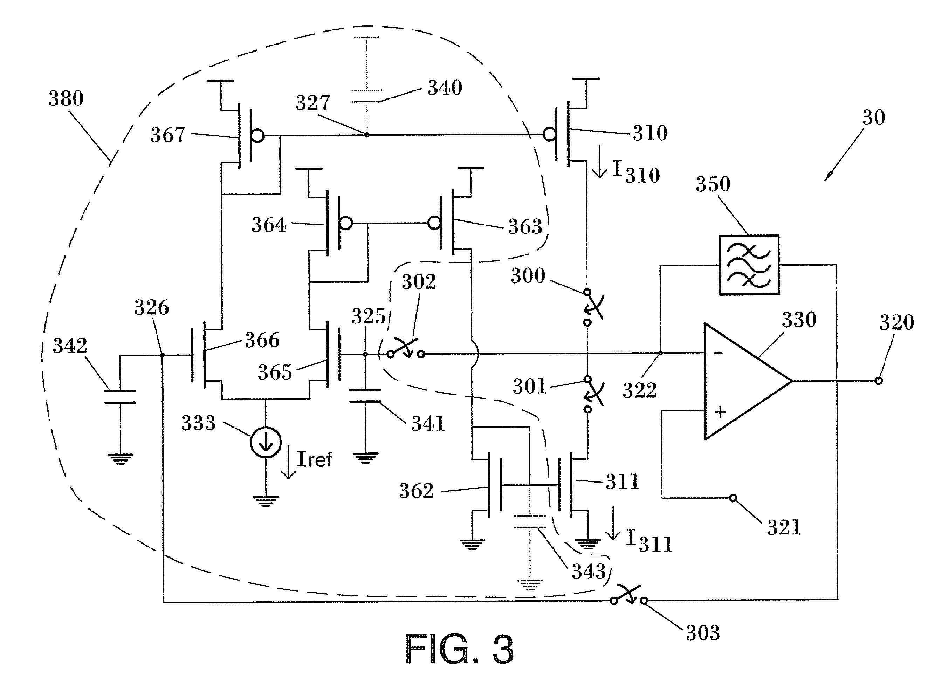

Figure 3 shows a charge pump circuit 30 comprising an automatic balancing circuitry according to a preferred embodiment of the present invention. In this implementation, transistor 310 acts as a current source (similar to current source 210 of figure 2) and transistor 311 acts as a current source (similar to current source 211 of figure 2). Like the circuit of figure 2, circuit 30 further has a second block 380 forming a calibration circuit. It comprises a second operational amplifier and a group of capacitances 340 341 342 343. Like block 280 of figure 2, this block 280 is connected to or disconnected from the main block through switch 302 and switch 303, as shown in figure 3. The operational amplifier of block 380 comprises several transistors 362 363 364 365 366 367 and a current source 333 providing a reference current Iref. It also has an output node 327 and two input nodes 325 326, similar to those of block 280 of figure 2. The output node 327 is connected to current source 310.

In figure 3, capacitances 340 and 343 are dotted because they do not represent physical components of the circuit 30. On the contrary, capacitive values 340 343 exist due to the intrinsic capacitance of the respective MOS transistor 367 362 between its gate and source.

The circuit 30 of figure 3 works as follows: Current source 333 drains a current equal to Iref. Thus, the total current which passes through transistors 364 and 367 must be equal to Iref (Iref = I₃₆₇ + I₃₆₄), because, as apparent for the one skilled in the art, if two transistors share the gate node and have the same size, their currents must be equal in typical working conditions. Therefore, the current passing through transistor 311 (I₃₁₁) must be equal to the current passing through transistor 362 (I₃₆₂) (I₃₁₁= I₃₆₂), which in turn is equal to the current passing through transistor 363 (I₃₆₃) (I₃₁₁= I₃₆₂= I₃₆₃) and, finally, to the current passing through transistor 364 (I₃₆₄) (I₃₁₁= I₃₆₂= I₃₆₃= I₃₆₄). Since I₃₁₀ is equal to I₃₆₇, going back to the original relationship Iref = I₃₆₇ + I₃₆₄, then Iref = I₃₁₀ + I₃₁₁. Consequently, block 380 works as an amplifier and, apart from making equal the currents I₃₁₀ I₃₁₁ of sources 310 311, it assures that these currents are equal to Iref/2 (I₃₁₀ = I₃₁₁ = Iref/2) .

From this implementation, we can see other benefits of the present invention: Block 380 is more robust in terms of noise coming from the current source 333 (providing a current of Iref). Since current sources are one of the most important noise sources in CMOS circuits, this implementation manages to reduce this disadvantage, because at node 322, noise coming from source 333 arrives through two opposite paths, cancelling therefore their incidence.

In all these embodiments illustrated in figures 2 and 4, it can be appreciated how the problems derived from the prior art charge pump circuits are overcome: The intrinsic mismatch between the current sources derived from the fabrication process is overcome by directly controlling one of the current sources. Furthermore, in our invention, the calibration circuit or second block is disconnected when the charge pump operates in normal mode.

Figure 5 shows a frequency synthesizer phase-locked loop comprising the charge pump circuit 20, 30 of any of the two described embodiments of the invention. It shows a schematic representation of a typical PLL system, used for generating, in this particular case, a 2.4GHz signal. Of course, the system can be used to generate a signal having a different frequency.

It comprises a controllable device, such as a Voltage controlled Oscillator (VCO) 52 that generates a signal around 2.4GHz. In order to check if this frequency is correct, the signal frequency is divided by a divider 53 in order to compare it to a known frequency source 54, which acts as a reference signal. Depending on this comparison, an action on the VCO is taken or not. In other words; the voltage-controlled oscillator (VCO) 52 outputs a signal whose frequency depends on the voltage input Vout. This signal is normally a high frequency signal. This high frequency signal enters in a frequency divider 53, which outputs a signal whose frequency is N times lower than the input signal (in this case N = 150). The resulting output signal has therefore a frequency of around 16 MHz. This resulting signal enters a Phase-Frequency Detector (PFD) 51. This block 51 compares the 16MHz of the PLL loop with a 16MHz Reference signal, generated by a frequency source 54, such as a very precise crystal oscillator. Depending on which signal (the output of the divider 53 or the output of the frequency source 54) has a lower frequency, the PFD 51 activates an "Up" signal or a "Down" signal, respectively.

Finally, closing the loop, the Charge Pump circuit 50 is placed. This block 50, corresponding to circuits 20 30 of figures 2 and 3, outputs a signal Vout (at node 220 in figure 2 and node 320 in figure 3) whose voltage level increases or decreases by activating the Up and Down signals, respectively.

Therefore, in an ideal case, when the VCO 52 is oscillating exactly at 2.4GHz, the output signals of the PFD block 51 are inactive, the voltage Vout thus remaining constant. But, if for any reason, the frequency of the VCO 52 decreases, the PDF 51 activates the UP signal, as a consequence of which the Vout voltage increases, therefore increasing VCO 52 the VCO output frequency. The same analysis can be inversely applied if the oscillation frequency goes over 2.4GHz.

In this text, the term "comprises" and its derivations (such as "comprising", etc.) should not be understood in an excluding sense, that is, these terms should not be interpreted as excluding the possibility that what is described and defined may include further elements, steps, etc.

The invention is obviously not limited to the specific embodiments described herein, but also encompasses any variations that may be considered by any person skilled in the art (for example, as regards the choice of components, configuration, etc.), within the general scope of the invention as defined in the appended claims.

## Claims

1. A charge pump circuit (20, 30) comprising:
a first operational amplifier (230, 330) having a first input node (221, 321), a second input node (222, 322) and an output node (220, 320), said first operational amplifier (230, 330) being configured for adjusting the voltage at said output node (220, 320) to a reference value provided at said first input node (221, 321);
a first current source (210, 310) and a second current source (211, 311) for providing respective first (I₂₁₀, I₂₁₁) and second (I₃₁₀, I₃₁₁) currents to said second input node (222, 322);
a first switch (200, 300) and a second switch (201, 301) respectively configured for determining the amount of current (I₂₁₀, I₂₁₁; I₃₁₀, I₃₁₁) delivered to said second input node (222, 322);
a loop filter (250, 350) connected between said second input node (222, 322) and said output node (220, 320), said loop filter (250, 350) being configured for integrating a current difference between said first (I₂₁₀, I₂₁₁) and second (I₃₁₀, I₃₁₁) currents provided at said second input node (222, 322);
**characterised in that** it further comprises an automatic calibration circuit (280, 380) configured for directly controlling the current (I₂₁₀, I₃₁₀) provided by said first current source (210, 310).

2. The charge pump circuit (20, 30) according to claim 1, wherein said automatic calibration circuit (280, 380) comprises a second operational amplifier (231, 331) having a first input node (225, 325), a second input node (226, 326) and an output node (227, 327), wherein said output node (227, 327) is connected to said first current source (210, 310).

3. The charge pump circuit (20, 30) according to claim 2, wherein said second input node (226, 326) of said second operation amplifier (230, 330) is connected to the output node (220, 320) of said first operational amplifier (230, 330) through a third switch (203, 303) and said first input node (225, 325) of said second operation amplifier (230, 330) is connected to the second input node (222, 322) of said first operation amplifier (231, 232) through a fourth switch (202, 302).

4. The charge pump circuit (20, 30) according to either claim 2 or 3, wherein said automatic calibration circuit (280, 380) further comprises a first capacitance (241, 341) connected to said first input node (225, 325) of said second operation amplifier (230, 330) and a second capacitance (242, 342) connected to said second input node (226, 326) of said second operation amplifier (230, 330), said capacitances having their respective opposing end connected to ground, said first (241, 341) and second (242, 342) capacitances being configured for storing their voltage value.

5. The charge pump circuit (20, 30) according to any claims 2 to 4, wherein said automatic calibration circuit (280, 380) further comprises a third capacitance (240, 340) connected to said output node (227, 327) of said second operation amplifier (230, 330).

6. The charge pump circuit (20, 30) according to any preceding claim, wherein at least one of said first current source (210, 310) and said second current source (211, 311) is implemented by means of a PMOS transistor.

7. The charge pump circuit (20, 30) according to any preceding claim, said circuit being configured for having two modes of operation: a calibration mode when both third and fourth switches (202, 302; 203, 303) are closed and a normal charge pump mode when both third and fourth switches (202, 302; 203, 303) are open.

8. A frequency synthesizer phase-locked loop comprising a charge pump circuit (20, 30, 50) according to any preceding claim.

9. A system comprising a frequency synthesizer phase-locked loop according to claim 8.

10. The system of claim 9, wherein said system is a radio-frequency communications system.

11. A method of calibrating a charge pump circuit (20, 30), said charge pump circuit (20, 30) comprising a first operational amplifier (230, 330) having a first input node (221, 321), a second input node (222, 322) and an output node (220, 320); a first current source (210, 310) and a second current source (211, 311) for providing respective first (I₂₁₀, I₂₁₁) and second (I₃₁₀, I₃₁₁) currents to said second input node (222, 322); a first switch (200, 300) and a second switch (201, 301) respectively configured for determining the amount of current (I₂₁₀, I₂₁₁; I₃₁₀, I₃₁₁) delivered to said second input node (222, 322); a loop filter (250, 350) connected between said second input node (222, 322) and said output node (220, 320), said loop filter (250, 350) being configured for integrating a current difference between said first (I₂₁₀, I₂₁₁) and second (I₃₁₀, I₃₁₁) currents provided at said second input node (222, 322);
the method comprising the steps of:
- detecting at a first input (226, 326) of a second operation amplifier a voltage value measured at the output (220, 320) of said first operation amplifier (230, 330);
- comparing said detected voltage value to the voltage value at said first input (22, 322) of said first operation amplifier (230, 330);
- producing an output voltage at the output (227, 327) of said second operation amplifier, said output voltage being proportional to said detected voltage value;
- adjusting the current (I₂₁₀, I₃₁₀) of said first current source (210, 310) by means of said output voltage produced at said output (227, 327) of said second operation amplifier.
